# EUROPEAN PATENT SPECIFICATION

(11) **EP 0 472 112 B1**
(45) Date of publication and mention of the grant of the patent: **06.11.1996**
(21) Application number: 91113672.9
(22) Date of filing: 14.08.1991
(51) Int. Cl.: B01J 3/03, B01J 3/00, B01J 3/02, B01J 19/02, B65D 51/16, F16J 13/16

(54) **Method and apparatus for covering an inner region of a vacuum chamber**
Verfahren und Vorrichtung zum Abdecken des Innenraums einer Vakuumkammer
Méthode et appareil pour couvrir une région interne d'une chambre à vide

(30) Priority: 16.08.1990 US 568394
(43) Date of publication of application: 26.02.1992
(73) Proprietor: APPLIED MATERIALS, INC., Santa Clara California 95054-3299 (US)
(72) Inventor: Ebbing, Peter, Los Altos, CA 94024 (US)
(74) Representative: DIEHL GLAESER HILTL & PARTNER

(56) References cited:
- DE-A- 3 324 931
- DE-C- 62 753
- DE-U- 1 888 623
- DE-U- 8 405 991

## Description

The present invention relates to a method and apparatus for covering an inner region of a vacuum chamber.

High vacuum equipment, for example, vacuum chambers such as processing chambers and load lock chambers used in the processing of integrated circuits, are frequently pumped down and vented up. Due to the constant change in pressure, a door or a cover to a chamber may be caused to flex. Unless the door or cover is sufficiently stiff and bolted down, the flexing of the door or cover will result in the door or cover rubbing at the location where the door or cover touches the chamber walls. Such rubbing generates particles which can enter the chamber as contaminants. Particulates also may be generated, to a lesser degree, by the inward flexing surface of the cover.

In view of this situation, the invention provides a combination for covering the inner region of a vacuum chamber according to independent claim 1 and a method for doing so according to independent claim 8. Further advantageous features, aspects and details of the invention are evident from the dependent claims, the description and the drawings. The claims are intended to be understood as a first non-limiting approach of defining the invention in general terms.

The invention provides a reducing particulate generation caused by door or cover flexing on high vacuum equipment and a design of covers and doors for high vacuum equipment to reduce particulate generation which is caused by flexing.

In accordance with the preferred embodiments of the present invention, a method and apparatus are presented for covering an inner region of a vacuum chamber. an inner lid, attached to the vacuum chamber, covers the inner region. an outer lid, also attached to the vacuum chamber, covers the inner lid, leaving a region between the inner lid and the outer lid. A gas conduit allows gas to flow between the inner region of the vacuum chamber and the region between the inner lid and the outer lid. A filter is placed in or immediately outside the gas conduit to prevent particles from entering the inner region of the vacuum chamber from the region between the inner lid and the outer lid. Since the pressure is the same on the top and bottom of the inner lid, the inner lid does not flex and does not rub against the vacuum chamber when the vacuum chamber is pumped down or vented up.

In an alternate embodiment of the preferred embodiment of the present invention, an inner lid, attached to the vacuum chamber, covers the inner region. An outer lid, also attached to the vacuum chamber, covers the inner lid, leaving a region between the inner lid and the outer lid. A first gas conduit allows the inner region to be pumped down or vented up. A second gas conduit allows the region between the inner lid and the outer lid to be pumped down or vented up. However, while being pumped down or vented up, the inner region of the vacuum chamber and the region between the inner lid and the outer lid are kept at the same relative pressure. Since the pressure is the same on the top and bottom of the inner lid, the inner lid does not flex and does not rub against the vacuum chamber when the vacuum chamber is pumped down or vented up.

Figure 1 is a simplified cross-sectional view of a vacuum chamber with a cover designed according to a preferred embodiment of the present invention.

Figure 2 is a simplified cross-sectional view of a vacuum chamber with a door designed according to an alternate preferred embodiment of the present invention.

Figure 3 is a simplified cross-sectional view of a vacuum chamber according to an another alternate preferred embodiment of the present invention.

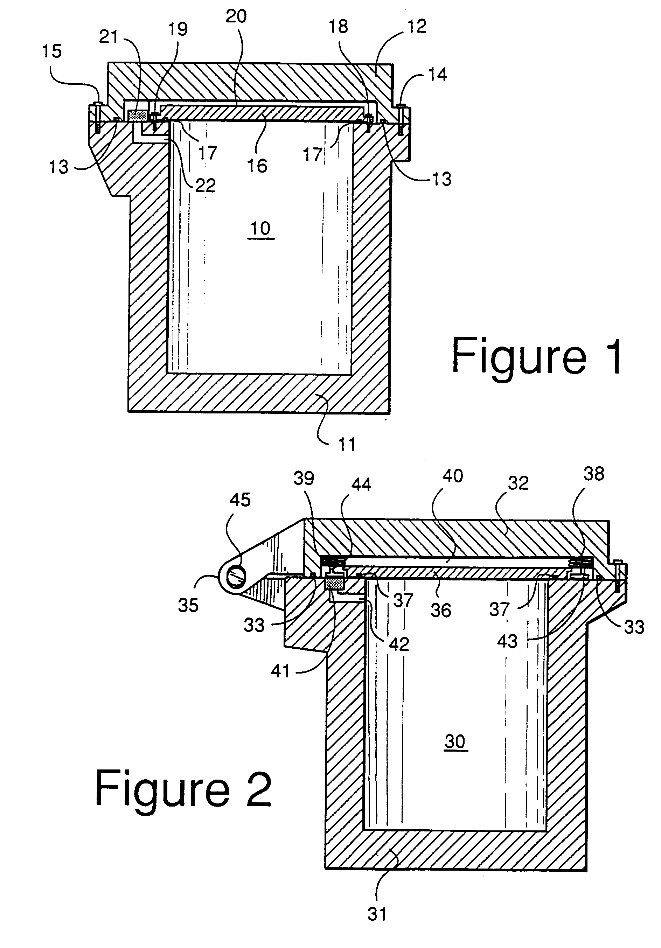

In Figure 1 is shown a simplified cross-sectional view of a vacuum chamber 11. During pump down, a vacuum is introduced into an inner region 10 of vacuum chamber 11.

An inner cover 16 is secured to vacuum chamber 11, for example, by screws including a screw 18 and a screw 19. A seal 17 prevents leakage around inner cover 16. An outer cover 12 is secured to vacuum chamber 11, for example, by screws including a screw 14 and a screw 15. A seal 13 prevents leakage around outer cover 12.

A conduit 22 connects inner region 10 to a region 20 between inner cover 16 and outer cover 12. Gas flowing through conduit 22 keeps region 20 and inner region 10 at the same pressure. The volume of region 20 is minimized to limit the volume of gas that needs to be removed from inner region 10 during pump down.

Since the pressure is the same on the top and bottom of inner cover 16, inner cover 16 does not flex and thus does not rub against chamber 11 when chamber 11 is pumped down or vented up. A filter 21 prevents particles, which may be generated by rubbing of outer cover 12 against chamber 11 resulting from flexing of outer cover 12, from entering inner region 10.

One of numerous alternate embodiments of the present invention is illustrated by the simplified cross-sectional view of a vacuum chamber shown in Figure 2.

In Figure 2, an inner cover 36 is secured to vacuum chamber 31, for example, by restraints including a spring 38 on a guide 43 and a spring 39 on a guide 44. A seal 37 prevents leakage around inner cover 36. An outer door 32 on a hinge 35 is secured to vacuum chamber 31, for example, by screws including a screw 34. A seal 33 prevents leakage around outer door 32. When outer door 32 is opened, guide 43 and guide 44 capture inner cover 36, causing inner cover 36 to open with outer door 32.

In order to insure that outer door 32 seals tightly to vacuum chamber 31, it is recommended that hinge 35 have some play, as illustrated by oblong shaped hole 45. This allows outer door 32 to fully seat against vacuum chamber 31 when a vacuum is introduced into inner region 30.

A conduit 42 connects an inner region 30 to a region 40 between inner cover 36 and outer door 32. Gas flowing through conduit 42 keeps region 40 and inner region 30 at the same pressure. The volume of region 40 is minimized to limit the volume of gas that needs to be removed from inner region 30 during pump down.

Since the pressure is the same on the top and bottom of inner cover 36, inner cover 36 does not flex and thus does not rub against chamber 31 when chamber 31 is pumped down or vented up. A filter 41 prevents particles, which may be generated by rubbing of outer door 32 against chamber 31 resulting from flexing of outer door 32, from entering inner region 30.

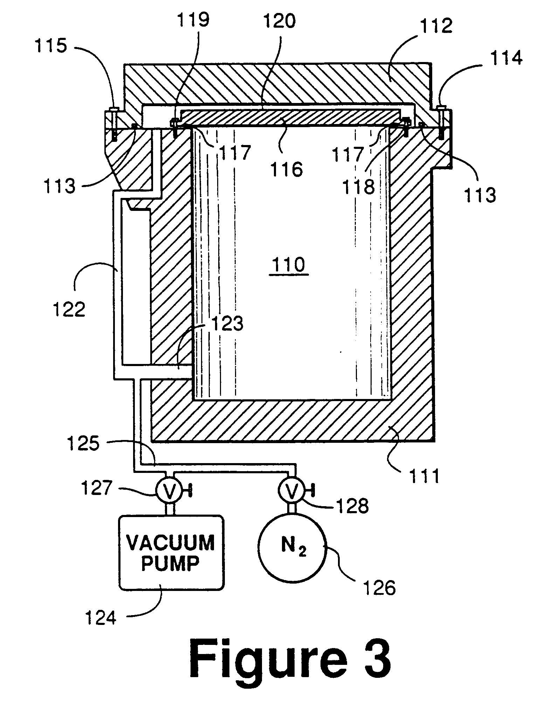

Another alternate embodiment of the present invention is shown in Figure 3. In Figure 3, an inner cover 116 is secured to vacuum chamber 111, for example, by screws including a screw 118 and a screw 119. A seal 117 prevents leakage around inner cover 116. An outer cover 112 is secured to vacuum chamber 111, for example, by screws including a screw 114 and a screw 115. A seal 113 prevents leakage around outer cover 112.

A conduit 123 connected to a conduit 125 connects inner region 110 to a vacuum pump 124 and to a nitrogen tank 126. A conduit 122 connected to conduit 125 connects a region 120 between inner cover 116 and outer cover 112 to vacuum pump 124 and to nitrogen tank 128. Vacuum pump 124 pumps down inner region 110 and region 120 so that region 120 and inner region 110 are at the same relative pressure. During the pump down process and while inner region 110 and region 120 are pumped down, a valve 128 isolates nitrogen chamber 128 from conduit 125. The volume of region 120 is minimized to limit the volume of gas that needs to be removed during pump down.

Since vacuum pump 124 keeps pressure on the top and bottom of inner cover 116 at the same relative pressure, inner cover 116 does not flex and does not rub against chamber 111 when chamber 111 is pumped down.

When inner region 110 and region 120 are vented up, nitrogen is slowly released into conduit 125 from nitrogen chamber 126. Region 120 and inner region 110 are vented up while remaining at the same relative pressure. During the vent up process a valve 127 isolates vacuum pump 124 from conduit 125. During vent up, the pressure on the top and bottom of inner cover 116 is kept at the same relative pressure and inner cover 116 does not flex and does not rub against chamber 111 when chamber 111 is vented. During pump down and vent up the system should typically maintain the pressure differential across inner cover 116 below 200 Millitorr.*
* 1 milliTorr = 1.3 x 10⁻³ mbar

## Claims

1. A combination for covering an inner region (10, 30, 110) of a vacuum chamber (11, 31, 111), the combination comprising:
inner covering means (16, 36, 116), coupled to the vacuum chamber (11, 31, 111) for covering the inner region (10, 31, 110) of the vacuum chamber;
outer covering means (12, 32, 112), coupled to the vacuum chamber (11, 31, 111), for covering the inner covering means (16, 36, 116) leaving a region (20, 40, 120) between the inner covering means (16, 36, 116) and the outer covering means (12, 32, 112); and
gas conduit means (22, 42, 122, 123) in communication with the inner region (10, 30, 110) of the vacuum chamber (11, 31, 111) and the region (20, 40, 120) between the inner covering means (16, 36, 116) and the outer covering means (12, 32, 112).

2. A combination as in claim 1 wherein the gas conduit means are a conduit (22, 42) extending between the inner region (10, 30) of the vacuum chamber (11, 31) and the region (20, 40) between the inner covering means (16, 36) and the outer covering means (12, 32).

3. A combination as in claim 2, additionally comprising a filter (21, 41) coupled to the gas conduit.

4. A combination as in claim 1 wherein said gas conduit means comprise
first gas conduit (123) from the inner region (110) of the vacuum chamber (111) to a vacuum pump (124) and to a vent up gas source (126); and,
second gas conduit (122) from the region (120) between the inner covering means (116) and the outer covering means (112) to the vacuum pump (124) and to the vent up gas source (126).

5. A combination as in one of the preceding claims, wherein the outer covering means (32) is a door on a hinge (35).

6. A combination as in one of claims 1 to 4, wherein the outer covering means (12) is a cover attached to the vacuum chamber (11) by fastening devices (15).

7. A combination as in one of the preceding claims wherein the inner covering means (36) is held tight to the vacuum chamber (31) by a plurality of springs (38, 39) connected to the outer covering means (36).

8. A method for covering an inner region of a vacuum chamber, the method comprising the steps of:
a) covering the inner region of the vacuum chamber with an inner lid;
b) covering the inner lid with an outer lid leaving a region between the inner lid and the outer lid; and
c1) allowing gas flow between the inner region of the vacuum chamber and the region between the inner lid and the outer lid; or
c2) pumping down the inner region of the vacuum chamber and the region between the inner lid and the outer lid so that the inner regions of the vacuum chamber and the region between the inner lid and the outer lid have the same pressure.

9. A method as in claim 8 additionally comprising after step c1) the step
d1) filtering gas that flows from the region between the inner lid and the outer lid to the inner region of the vacuum chamber.

10. A method as in claim 8 additionally comprising after step c2) the step
d2) venting up the inner region of the vacuum chamber and the region between the inner lid and the outer lid so that the inner regions of the vacuum chamber and the region between the inner lid and the outer lid have the same pressure.

11. A method as in one of claims 8 to 10, wherein the outer lid is a door on a hinge.

12. A method as in one of claims 8 to 11, wherein the step (b) is accomplished by attaching the outer lid to the vacuum chamber with fastening devices.

13. A method as in one of claims 8 to 11, wherein step (b) includes holding the inner lid tight to the vacuum chamber by a plurality of springs connected to the outer lid.

## Patentansprüche

1. Kombination zum Abdecken eines Innenbereichs (10, 30, 110) einer Vakuumkammer (11, 31, 111), wobei die Kombination folgendes aufweist:
ein Innenabdeckmittel (16, 36, 116), das mit der Vakuumkammer (11, 31, 111) verbunden ist, um den Innenbereich (10, 30, 110) der Vakuumkammer abzudecken;
ein Außenabdeckmittel (12, 32, 112), das mit der Vakuumkammer (11, 31, 111) verbunden ist, um das Innenabdeckmittel (16, 36, 116) abzudecken, wobei ein Bereich (20, 40, 120) zwischen dem Innenabdeckmittel (16, 36, 116) und dem Außenabdeckmittel (12, 32, 112) bleibt; und
Gasleitungsmittel (22, 42, 122, 123) in Verbindung mit dem Innenbereich (10, 30, 110) der Vakuumkammer (11, 31, 111) und dem Bereich (20, 40, 120) zwischen dem Innenabdeckmittel (16, 36, 116) und dem Außenabdeckmittel (12, 32, 112).

2. Kombination gemäß Anspruch 1, bei der es sich bei den Gasleitungsmitteln um eine Leitung (22, 42) handelt, welche zwischen dem Innenbereich (10, 30) der Vakuumkammer (11, 31) und dem Bereich (20, 40) zwischen dem Innenabdeckmittel (16, 36) und dem Außenabdeckmittel (12, 32) verläuft.

3. Kombination gemäß Anspruch 2, die zusätzlich einen mit der Gasleitung verbundenen Filter (21, 41) aufweist.

4. Kombination gemäß Anspruch 1, bei der die Gasleitungsmittel folgendes aufweisen:
eine erste Gasleitung (123) von dem Innenbereich (110) der Vakuumkammer (111) zu einer Vakuumpumpe (124) und zu einer Belüftungsgasquelle (126); und
eine zweite Gasleitung (122) von dem Bereich (120) zwischen dem Innenabdeckmittel (116) und dem Außenabdeckmittel (112) zu der Vakuumpumpe (124) und zu der Belüftungsgasquelle (126).

5. Kombination gemäß einem der vorhergehenden Ansprüche, bei der es sich bei dem Außenabdeckmittel (32) um eine Tür an einem Scharnier (35) handelt.

6. Kombination gemäß einem der Ansprüche 1 bis 4, bei der es sich bei dem Außenabdeckmittel (12) um eine durch Befestigungsvorrichtungen (15) an der Vakuumkammer (11) angebrachte Abdeckung handelt.

7. Kombination gemäß einem der vorhergehenden Ansprüche, bei der das Innenabdeckmittel (36) durch eine Mehrzahl an Federn (38, 39), welche mit dem Außenabdeckmittel (32) verbunden sind, eng an der Vakuumkammer (31) gehalten ist.

8. Verfahren zum Abdecken eines Innenbereichs einer Vakuumkammer, wobei das Verfahren folgende Schritte aufweist:
a) Abdecken des Innenbereichs der Vakuumkammer mit einem Innendeckel;
b) Abdecken des Innendeckels mit einem Außendeckel, wobei ein Bereich zwischen dem Innendeckel und dem Außendeckel bleibt; und
c1) Ermöglichung eines Gasflusses zwischen dem Innenbereich der Vakuumkammer und dem Bereich zwischen dem Innendeckel und dem Außendeckel; oder
c2) Auspumpen des Innenbereichs der Vakuumkammer und des Bereichs zwischen dem Innendeckel und dem Außendeckel, so daß die Innenbereiche der Vakuumkammer und der Bereich zwischen dem Innendeckel und dem Außendeckel denselben Druck aufweisen.

9. Verfahren gemäß Anspruch 8, das zusätzlich nach Schritt c1) den Schritt
d1) Filtern von Gas, das von dem Bereich zwischen dem Innendeckel und dem Außendeckel zum Innenbereich der Vakuumkammer strömt,
aufweist.

10. Verfahren gemäß Anspruch 8, das zusätzlich nach Schritt
c2) den Schritt
d2) Belüften des Innenbereichs der Vakuumkammer und des Bereichs zwischen dem Innendeckel und dem Außendeckel, so daß die Innenbereiche der Vakuumkammer und der Bereich zwischen dem Innendeckel und dem Außendeckel denselben Druck aufweisen,
umfaßt.

11. Verfahren gemaß einem der Ansprüche 8 bis 10, bei dem es sich bei dem Außendeckel um eine Tür an einem Scharnier handelt.

12. Verfahren gemäß einem der Ansprüche 8 bis 11, bei dem Schritt (b) durch Anbringen des Außendeckels an der Vakuumkammer mittels Befestigungsvorrichtungen erfolgt.

13. Verfahren gemäß einem der Ansprüche 8 bis 11, bei dem Schritt (b) das enganliegende Halten des Innendeckels an der Vakuumkammer durch eine Mehrzahl an Federn, welche mit dem Außendeckel verbunden sind, umfaßt.

## Revendications

1. Combinaison pour la couverture d'une région interne (10, 30, 110) d'une chambre à vide (11, 31, 111), ladite combinaison comprenant :
des moyens de couverture internes (16, 36, 116), couplés à la chambre à vide (11, 31, 111) pour couvrir la région interne (10, 30, 110) de la chambre à vide ;
des moyens de couverture externes (12, 32, 112), couplés à la chambre à vide (11, 31, 111), pour couvrir les moyens de couverture internes (16, 36, 116) en laissant une région (20, 40, 120) entre les moyens de couverture internes (16, 36, 116) et les moyens de couverture externes (12, 32, 112) ; et
des moyens formant conduit de gaz (22, 42, 122, 123) en communication avec la région interne (10, 30, 110) de la chambre à vide (11, 31, 111) et la région (20, 40, 120) comprise entre les moyens de couverture internes (16, 36, 116) et les moyens de couverture externes (12, 32, 112).

2. Combinaison selon la revendication 1, dans laquelle lesdits moyens formant conduit de gaz sont constitués par un conduit (22, 42) s'étendant entre la région interne (10, 30) de la chambre à vide (11, 31) et la région (20, 40) comprise entre les moyens de couverture internes (16, 36) et les moyens de couverture externes (12, 32).

3. Combinaison selon la revendication 2, comprenant en outre un filtre (21, 41) couplé au conduit de gaz.

4. Combinaison selon la revendication 1, dans laquelle lesdits moyens formant conduit de gaz comprennent :
un premier conduit de gaz (123) allant de la région interne (110) de la chambre à vide (111) à une pompe à vide (124) et à une source de gaz de ventilation (126) ; et
un second conduit de gaz (122) provenant de la région (120) comprise entre les moyens de couverture internes (116) et les moyens de couverture externes (112) vers la pompe à vide (124) et la source de gaz de ventilation (126).

5. Combinaison selon l'une des revendications précédentes, dans laquelle les moyens de couverture externes (32) sont constitués d'une porte (35) montée sur une charnière.

6. Combinaison selon l'une des revendications 1 à 4, dans laquelle les moyens de couverture externes (12) sont constitués d'un couvercle fixé à la chambre à vide (11) par des dispositifs de fixation (15).

7. Combinaison selon l'une des revendications précédentes, dans laquelle les moyens de couverture internes (36) sont retenus hermétiquement sur la chambre à vide (31) au moyen d'une serie de ressorts (38, 39) connectés aux moyens de couverture externes (32).

8. Procédé de couverture d'une région interne d'une chambre à vide, le procédé comprenant les étapes suivantes :
a) la couverture de la région interne de la chambre à vide avec un couvercle interne ;
b) la couverture du couvercle interne avec un couvercle externe en laissant une région comprise entre le couvercle interne et le couvercle externe ; et
c1) la circulation d'un gaz entre la région interne de la chambre à vide et la région comprise entre le couvercle interne et le couvercle externe ; ou
c2) le pompage de la région interne de la chambre à vide et de la région comprise entre le couvercle interne et le couvercle externe de telle sorte que les régions internes de la chambre à vide et la région comprise entre le couvercle interne et le couvercle externe sont à la même pression.

9. Procédé selon la revendication 8, comprenant, après l'étape c1), l'étape suivante :
d1) la filtration d'un gaz qui s'écoule depuis la région comprise entre le couvercle interne et le couvercle externe vers la région interne de la chambre à vide.

10. Procédé selon la revendication 8, comprenant en outre, après l'étape c2), l'étape suivante :
d2) la ventilation de la région interne de la chambre à vide et de la région comprise entre le couvercle interne et le couvercle externe de telle sorte que les régions internes de la chambre à vide et la région comprise entre le couvercle interne et le couvercle externe sont à la même pression.

11. Procédé selon l'une des revendications 8 à 10, dans lequel le couvercle externe est une porte montée sur une charnière.

12. Procédé selon l'une des revendications 8 à 11, dans lequel l'étape (b) est mise en oeuvre en fixant le couvercle externe à la chambre à vide au moyen de dispositifs de fixation.

13. Procédé selon l'une des revendications 8 à 11, dans lequel l'étape (b) comprend la retenue étanche du couvercle interne sur la chambre à vide au moyen d'une pluralité de ressorts connectés au couvercle externe.
